# EUROPEAN PATENT SPECIFICATION

(11) **EP 3 373 266 B1**
(45) Date of publication and mention of the grant of the patent: **15.07.2020**
(21) Application number: 16861459.2
(22) Date of filing: 25.10.2016
(51) Int. Cl.: G08C 19/00, G01R 31/00

(54) **METHOD, APPARATUS, AND SYSTEM FOR DETECTING WORKING STATE OF PHOTOVOLTAIC PANEL, AND PHOTOVOLTAIC ELECTRICAL SYSTEM**
VERFAHREN, VORRICHTUNG UND SYSTEM ZUR ERKENNUNG DES BETRIEBSZUSTANDS EINES FOTOVOLTAIKPANEELS UND FOTOVOLTAISCH-ELEKTRISCHES SYSTEM
PROCÉDÉ, APPAREIL ET SYSTÈME DE DÉTECTION D'ÉTAT DE FONCTIONNEMENT DE PANNEAU PHOTOVOLTAÏQUE, ET SYSTÈME ÉLECTRIQUE PHOTOVOLTAÏQUE

(30) Priority: 02.11.2015 CN 201510741827
(43) Date of publication of application: 12.09.2018
(73) Proprietor: Gree Electric Appliances, Inc. of Zhuhai, Zhuhai, Guangdong 519070 (CN)
(72) Inventor: JIANG, Shiyong, Zhuhai Guangdong 519070 (CN); FENG, Chongyang, Zhuhai Guangdong 519070 (CN); ZHANG, Xuefen, Zhuhai Guangdong 519070 (CN); WANG, Jing, Zhuhai Guangdong 519070 (CN); LIU, Keqin, Zhuhai Guangdong 519070 (CN); SONG, Jiangxi, Zhuhai Guangdong 519070 (CN); REN, Peng, Zhuhai Guangdong 519070 (CN); WEN, Wu, Zhuhai Guangdong 519070 (CN); LIN, Baowei, Zhuhai Guangdong 519070 (CN)
(74) Representative: Lavoix
(86) International application number: PCT/CN2016/103202
(87) International publication number: WO 2017/076191

(56) References cited:
- CN-A- 101 877 166
- CN-A- 103 986 182
- CN-A- 105 319 431
- CN-A- 105 515 207
- CN-A- 106 023 573
- CN-U- 202 384 835
- CN-U- 203 689 677
- CN-U- 204 423 624
- CN-U- 204 423 625
- CN-U- 204 423 626
- CN-U- 204 423 627
- CN-U- 204 423 628
- CN-U- 204 423 629
- CN-U- 204 423 630
- CN-U- 205 620 455
- CN-Y- 201 054 505
- US-A1- 2011 121 652
- US-B2- 8 325 059
- MENG, LINGBO et al.: "Design of the Power Carrier Communication Module in Monitoring System of the Photovoltaic Power Station", DIGITAL TECHNOLOGY & APPLICATION, no. 12, 31 December 2012 (2012-12-31), pages 17-19, XP009511033, ISSN: 1007-9416

## Description

The present application claims priority to Chinese Patent Application No. 201510741827.2, titled "METHOD, APPARATUS, AND SYSTEM FOR DETECTING WORKING STATE OF PHOTOVOLTAIC PANEL, AND PHOTOVOLTAIC ELECTRICAL SYSTEM", filed on November 2, 2015 with the State Intellectual Property Office of People's Republic of China.

### FIELD

The present disclosure relates to the field of communications, and in particular to a method, an apparatus and a system for detecting an operating state of a photovoltaic panel, as well as a photovoltaic electrical system.

### BACKGROUND

At present, with the increasing global energy crisis and the deteriorating of environment, it is becoming more and more urgent to develop and apply renewable energy and green energy for various industries. Therefore, it has become a development direction for the market to develop and apply energy-saving products and environment-friendly products. For example, technologies relating to photovoltaic air-conditioning systems and photovoltaic central air-conditioners have been developed maturely.

However, a control device is not in direct communication with a photovoltaic device, or the control device communicates with the photovoltaic device via an additionally arranged bus therebetween. In a case where the control device is not in direct communication with the photovoltaic device, an upper computer cannot know an operating state of a photovoltaic panel in the photovoltaic device. In a case where the control device communicates with the photovoltaic device via the additionally arranged bus therebetween, cost and structural appearance of the photovoltaic central air conditioning system may be affected. For example, in a case where the control device is not in direct communication with the photovoltaic panel in the photovoltaic air conditioning system, an upper computer of the photovoltaic air conditioning system cannot know an operating state of the photovoltaic panel. In a case where a bus is additionally arranged for communication, the cost and the structure appearance of the photovoltaic central air conditioning system are affected.

Document Meng, Chent ET AL. "Design of power carrier communication module in photovoltaic power station monitoring system", Digital Technology and Application, Issue 12, December 31, 2012, pages 17-19 discloses a design of a power carrier communication module in a photovoltaic power station monitoring system comprising a plurality of photovoltaic modules and a centralized grid-connected inverter.

For a problem that communication quality is degraded due to a long communication bus between a photovoltaic device and a control device in the conventional technology, no effective solution is proposed yet.

### SUMMARY

A main object of the present disclosure is to provide a method, an apparatus and a system for detecting an operating state of a photovoltaic panel as well as a photovoltaic electrical system, to solve a problem that communication quality is degraded due to a long communication bus between a photovoltaic device and a control device.

In order to achieve the above object, a method for detecting an operating state of a photovoltaic panel according to claim 1 is provided in an aspect of the present disclosure.

In order to achieve the above object, an apparatus for detecting an operating state of a photovoltaic panel according to claim 6 is further provided in another aspect of the present disclosure.

In order to achieve the above object, a system for detecting an operating state of a photovoltaic panel according to claim 8 is further provided in another aspect of the present disclosure.

Preferred embodiments of the invention are the subject matter of the dependent claims, whose content is to be understood as forming an integral part of the present description.

In the present disclosure, the photovoltaic panel is arranged in the photovoltaic electrical system. The photovoltaic electrical system includes the photovoltaic device and the control device. The photovoltaic device includes the photovoltaic panel and the modulator. The control device includes the demodulator. The photovoltaic device is connected to the control device via the direct current bus. The operating state of the photovoltaic panel is detected, to obtain the state parameter of the photovoltaic panel. The state parameter of the photovoltaic panel is modulated through the modulator to obtain the modulated signal, and the modulated signal is loaded onto the direct current bus. The modulated signal is transmitted to the demodulator through the direct current bus, to obtain the state parameter of the photovoltaic panel. In this way, the problem that the communication quality is degraded due to the long communication bus between the photovoltaic device and the control device is solved, thereby improving the quality of the communication between the photovoltaic device and the control device.

### BRIEF DESCRIPTION OF THE DRAWINGS

The accompanying drawings constituting a part of the present disclosure are used to provide a further understanding of the present disclosure, and the exemplary embodiments of the present disclosure and the description thereof are used to explain the present disclosure and do not constitute improper limitations to the present disclosure. In the drawings:
Figure 1 is a schematic diagram of a system for detecting an operating state of a photovoltaic panel according to a first embodiment of the present disclosure;
Figure 2 is a schematic diagram of a system for detecting an operating state of a photovoltaic panel according to a second embodiment of the present disclosure;
Figure 3 is a flowchart of a method for detecting an operating state of a photovoltaic panel according to an embodiment of the present disclosure;
Figure 4 is a schematic diagram of a variation of a voltage on a direct current bus without a carrier wave according to an embodiment of the present disclosure;
Figure 5 is a schematic diagram of a variation of a voltage on a direct current bus with a carrier wave according to an embodiment of the present disclosure; and
Figure 6 is a schematic diagram of an apparatus for detecting an operating state of a photovoltaic panel according to an embodiment of the present disclosure.

### DETAILED DESCRIPTION OF EMBODIMENTS

It should be noted that the embodiments in the present disclosure and the features in the embodiments may be combined with each other without any conflict. The technical solution of present disclosure is described in detail below with reference to the accompanying drawings and in conjunction with the embodiments.

In order to enable those skilled in the art to better understand the present disclosure, the technical solutions in the embodiments of the present disclosure are clearly and completely described below in conjunction with the drawings in the embodiments of the present disclosure. It is apparent that the described embodiments are only some of embodiments of the present disclosure, rather than all of the embodiments. Based on the embodiments of the present disclosure, all other embodiments obtained by a person skilled in the art without making any creative effort shall fall within the protection scope of the present disclosure.

It should be noted that the terms "first", "second" and the like in the specification and claims of the present disclosure and in the above drawings are used to distinguish similar objects and are not necessarily used to describe specific sequences or orders. It should be understood that terms used in this way may be interchanged as appropriate for the embodiments of the present disclosure described herein. In addition, the terms "include" and "have" and any variations thereof are intended to cover non-exclusive inclusions. For example, a process, a method, a system, a product or a device that includes a series of steps or units is not limited to those clearly listed steps or units, and may instead include other steps or units not explicitly listed or inherent to the process, method, product or device.

A system for detecting an operating state of a photovoltaic panel is provided according to the present disclosure.

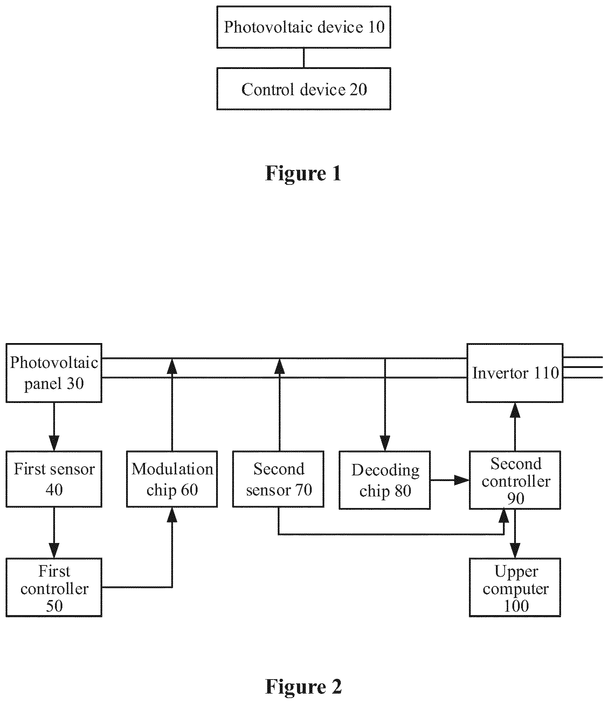

Figure 1 is a schematic diagram of a system for detecting an operating state of a photovoltaic panel according to a first embodiment of the present disclosure. As shown in Figure 1, the system for detecting an operating state of a photovoltaic panel includes a photovoltaic device 10 and a control device 20.

Preferably, the photovoltaic panel is arranged in a photovoltaic electrical system. The photovoltaic electrical system includes a photovoltaic device 10 and a control device 20. The photovoltaic device includes the photovoltaic panel and a modulator. The control device includes a demodulator. The photovoltaic device 10 is connected to the control device 20 via a direct current bus. Preferably, the photovoltaic device 10 communicates with the control device 20 for transmitting a state parameter of the photovoltaic panel of the photovoltaic device to the control device 20.

The photovoltaic device 10 is configured to detect the operating state of the photovoltaic panel, to obtain the state parameter of the photovoltaic panel. The modulator modulates the state parameter of the photovoltaic panel to obtain a modulated signal, and loads the modulated signal onto the direct current bus.

The system for detecting the operating state of the photovoltaic panel includes a photovoltaic electrical system, which includes the photovoltaic device 10. The photovoltaic device 10 includes the photovoltaic panel and the modulator. The photovoltaic panel, which is a solar panel, is a power generation apparatus that can generate direct current power when exposed to sunlight. The photovoltaic panel is almost completely composed of thin solid-state photovoltaic cells made of semi-conductor materials, and directly converts optical energy into electrical energy utilizing a photovoltaic effect on a semiconductor surface, to control a load to operate, or to transmit the electrical energy to a storage battery for storage. The photovoltaic panel has no movable part, such that the photovoltaic panel may be used reliably and stably for a long time. Thus the photovoltaic panel has a long service life and can be installed and maintained easily. The photovoltaic panel is arranged in the photovoltaic electrical system. For example, the photovoltaic panel is arranged in a photovoltaic air conditioning system, where the photovoltaic panel provides continuous electrical energy for the photovoltaic air conditioning system utilizing light energy, such that the photovoltaic air conditioning system operates reliably, stably and continuously. The photovoltaic device 10 further includes a first sensor and a first controller. The photovoltaic device 10 detects the state parameter of the photovoltaic panel through the first sensor. For example, the photovoltaic device 10 detects, through the first sensor, a voltage state parameter, a temperature state parameter and a position state parameter of the photovoltaic panel in the operation state. Optionally, the first sensor includes a voltage sensor, a temperature sensor and a position sensor. The photovoltaic device 10 detects a voltage state parameter of the photovoltaic panel through the voltage sensor, detects a temperature state parameter of the photovoltaic panel through the temperature sensor, and detects a position state parameter of the photovoltaic panel through the position sensor. After the photovoltaic device 10 detects the state parameter of the photovoltaic panel through the first sensor, the photovoltaic device 10 receives the state parameter of the photovoltaic panel through the first controller and controls the photovoltaic panel based on the state parameter of the photovoltaic panel. For example, the photovoltaic device 10 receives the position state parameter through the first controller and controls a position of the photovoltaic panel based on the position state parameter of the photovoltaic panel, such that the photovoltaic panel receives effective light energy in an effective area, thereby converting the effective light energy into effective electrical energy for the photovoltaic power supply system, for supporting normal operation of the photovoltaic power supply system.

After the photovoltaic device 10 receives the state parameter of the photovoltaic panel through the first controller, the photovoltaic device 10 modulates the state parameter of the photovoltaic panel through the modulator to obtain a modulated signal, and loads the modulated signal onto the direct current bus, where the modulated signal carries the state parameter of the photovoltaic panel. In an example, the photovoltaic device 10 also load the state parameter of the photovoltaic panel onto the direct current bus and transmit the state parameter of the photovoltaic panel to the control device via the direct current bus. The direct current bus is a total wire that converts alternating current power into direct current power and is used to transmit electrical energy. The direct current bus can transmit a large current, thereby improving power efficiency of the photovoltaic electrical system, and improving safety and reliability of the photovoltaic electrical system.

The control device 20 is configured to detect the modulated signal outputted from the direct current bus and demodulate the modulated signal through the demodulator to obtain the state parameter of the photovoltaic panel.

The system for detecting the operating state of the photovoltaic panel includes a photovoltaic electrical system, which includes a control device 20. The control device 20 includes a second sensor, a second controller and an upper computer. In an example, the control device 20 detects an output signal of the direct current bus through the second sensor. Optionally, the second sensor is a voltage sensor, and the control device 20 detects the output voltage of the direct current bus through the voltage sensor. The control device 20 demodulates the modulated signal outputted from the direct current bus through the demodulator to obtain the state parameter of the photovoltaic panel. The state parameter of the photovoltaic panel may be a voltage state parameter of the photovoltaic panel, a temperature state parameter of the photovoltaic panel, a position state parameter of the photovoltaic panel and the like. The demodulator may be a decoding chip that demodulates the modulated signal outputted from the direct current bus to obtain a demodulated signal, and extracts the state parameter of the photovoltaic panel from the demodulated signal. In this way, the state parameter of the photovoltaic panel of the photovoltaic device is transmitted to the control device, achieving the direct communication between the photovoltaic device and the control device.

After the control device 20 demodulates the modulated signal outputted from the direct current bus through the demodulator to obtain the state parameter of the photovoltaic panel, the control device 20 determines, through the second controller, whether the state parameter of the photovoltaic panel is successfully transmitted to the control device 20 based on the output signal of the direct current bus, to obtain a determination result. In an example, a cycle of communication between the photovoltaic device 10 and the control device 20 is a preset cycle, which includes successive periods of a first time period, a second time period and a third time period. In the second time period, the modulated signal is loaded onto the direct current bus or the modulated signal is demodulated. In the first time period, the output voltage of the direct current bus is detected through the voltage sensor to obtain a first voltage value. In the third time period, the output voltage of the direct current bus is detected through the voltage sensor to obtain a second voltage value. The second voltage value is an output voltage of the direct current bus obtained after the modulated signal is loaded onto the direct current bus or the modulated signal is demodulated in the second time period. It is determined, through the second controller, whether a difference between the first voltage value and the second voltage value is greater than a preset threshold. If the difference between the first voltage value and the second voltage value is greater than the preset threshold, it is determined that the state parameter of the photovoltaic panel is not successfully transmitted to the control device 20, that is, communication information is failed to be transmitted between the photovoltaic device 10 and the control device 20. If the difference between the first voltage value and the second voltage value is less than or equal to the preset threshold, it is determined that the state parameter of the photovoltaic panel is successfully transmitted to the control device 20, that is, the communication information is successfully transmitted between the photovoltaic device 10 and the control device 20.

After determining, through the second controller, whether the state parameter of the photovoltaic panel is successfully transmitted to the control device 20 based on an output signal of the direct current bus, the control device 20 uploads the determination result to the upper computer through the second controller, that is, the upper computer receives the determination result that the state parameter of the photovoltaic panel is not successfully transmitted to the control device 20, or the determination result that the state parameter of the photovoltaic panel is successfully transmitted to the control device 20. The upper computer also receives information collected by the second sensor and information collected by the demodulator, and further displays the information. The upper computer monitors the operating state of the photovoltaic panel based on the determination result. In a case where the upper computer receives the determination result that the state parameter of the photovoltaic panel is not successfully transmitted to the control device 20, the upper computer displays information that the state parameter of the photovoltaic panel is not successfully transmitted to the control device 20, to control the photovoltaic device 10 to re-detect the state parameter of the photovoltaic panel to obtain the state parameter of the photovoltaic panel. The state parameter of the photovoltaic panel is modulated through the modulator to obtain a modulated signal, and the modulated signal is loaded onto the direct current bus and is transmitted to the demodulator through the direct current bus. In a case where the upper computer receives the determination result that the state parameter of the photovoltaic panel is successfully transmitted to the control device 20, the upper computer displays information that the state parameter of the photovoltaic panel is successfully transmitted to the control device 20. Optionally, the upper computer displays the information collected by the second sensor and the information collected by the demodulator, and monitors the operating state of the photovoltaic panel in real time, such that a management person can know in real time whether the state parameter of the photovoltaic panel is within a normal range of the state parameter, and control the photovoltaic electrical system timely in a case where the photovoltaic electrical system operates abnormally, thereby avoiding failure of the photovoltaic electrical system and preventing further deterioration of a fault, and thus achieving better maintenance of the photovoltaic electrical system. The upper computer may further control the operating state of the photovoltaic panel based on the state parameter of the photovoltaic panel, such that the photovoltaic panel outputs a normal state parameter, thereby improving monitorability of the photovoltaic panel, and ensuing the safe, stable and reliable operation of the photovoltaic panel.

In the system for detecting the operating state of the photovoltaic panel, the photovoltaic panel is arranged in the photovoltaic electrical system. The photovoltaic electrical system includes the photovoltaic device and the control device. The photovoltaic device includes the photovoltaic panel and the modulator. The control device includes the demodulator. The photovoltaic device is connected to the control device via the direct current bus. The operating state of the photovoltaic panel is detected through the photovoltaic device to obtain the state parameter of the photovoltaic panel. The state parameter of the photovoltaic panel is modulated through the modulator to obtain the modulated signal, and the modulated signal is loaded onto the direct current bus. The output signal of the direct current bus is detected through the control device. The modulated signal is demodulated through the demodulator to obtain the state parameter of the photovoltaic panel. In this way, the state parameter of the photovoltaic panel of the photovoltaic device is transmitted to the control device, thereby improving the quality of the communication between the photovoltaic device and the control device.

Figure 2 is a schematic diagram of a system for detecting an operating state of a photovoltaic panel according to a second embodiment of the present disclosure. As shown in Figure 2, the system for detecting the operating state of the photovoltaic panel includes a photovoltaic panel 30, a first sensor 40, a first controller 50, a modulation chip 60, a second sensor 70, a decoding chip 80, a second controller 90, an upper computer 100 and an inverter 110.

The photovoltaic electrical system includes a photovoltaic device. The photovoltaic device includes the photovoltaic panel 30, the first sensor 40, the first controller 50 and the modulation chip 60.

The photovoltaic panel 30, which is a solar panel, is arranged in the photovoltaic electrical system. The photovoltaic electrical system may operate in a case where the photovoltaic panel converts light energy directly into electrical energy utilizing the photovoltaic effect. The photovoltaic panel 30 has no movable part, such that the photovoltaic panel 30 can be used reliably and stably for a long time. Thus the photovoltaic panel 30 has a long service life and can be installed and maintained easily. For example, the photovoltaic panel 30 is arranged in a photovoltaic air conditioning system, where the photovoltaic panel 30 provides continuous electric energy for the photovoltaic air conditioning system utilizing light energy, and outputs a state parameter such as a voltage state parameter, a temperature state parameter and a position state parameter, such that the photovoltaic air conditioning system operates reliably, stably and durably.

The first sensor 40 is connected to the photovoltaic panel 30 and is configured to detect the state parameter of the photovoltaic panel 30. Optionally, the first sensor includes a voltage sensor, a temperature sensor and a position sensor. The voltage state parameter of the photovoltaic panel 30 in the operation state is detected through the first sensor, the temperature state parameter of the photovoltaic panel 30 is detected through the temperature sensor, and the position state parameter of the photovoltaic panel 30 is detected through the position sensor.

The first controller 50 is connected to the first sensor 40 and is configured to receive the state parameter of the photovoltaic panel 30, and control the photovoltaic panel based on the state parameter of the photovoltaic panel 30. For example, the first controller 50 receives the voltage state parameter, the temperature state parameter and the position state parameter of the photovoltaic panel 30. Optionally, the first controller 50 controls the position of the photovoltaic panel based on the position state parameter of the photovoltaic panel 30, such that the photovoltaic panel 30 is adjusted to an optimal position state, to convert effective light energy into effective electric power for the photovoltaic power supply system, for supporting normal operation of the photovoltaic power supply system.

An input terminal of the modulation chip 60 is connected to the first controller 50, and an output terminal of the modulation chip is connected to the direct current bus. The modulation chip 60 is configured to modulate the state parameter of the photovoltaic panel 30 to obtain a modulated signal and load the modulated signal onto the direct current bus. The modulation chip 60 loads the state parameter of the photovoltaic panel 30, for example, the voltage state parameter, the temperature state parameter and the position state parameter of the photovoltaic panel, onto the direct current bus and transmits the state parameter of the photovoltaic panel 30 to the control device through the direct current bus, thereby improving power efficiency of the photovoltaic electrical system, and improving safety and reliability of the photovoltaic electrical system.

The photovoltaic electrical system includes a control device. The demodulator is arranged in the control device and is configured to detect the modulated signal outputted from the direct current bus and demodulate the modulated signal to obtain the state parameter of the photovoltaic panel. The control device includes a second sensor 70, a decoding chip 80, a second controller 90 and an upper computer 100.

The second sensor 70 is connected to the direct current bus and is configured to detect the output signal of the direct current bus. Optionally, the second sensor is a voltage sensor, and the control device detects the output voltage of the direct current bus through the voltage sensor. The cycle of the communication between the photovoltaic device and the control device is a preset cycle, which includes successive periods of a first time period, a second time period, and a third time period. In the second time period, the modulated signal is loaded onto the direct current bus or the modulated signal is demodulated. The voltage sensor detects the output voltage of the direct current bus in the first time period to obtain a first voltage value. The voltage sensor detects the output voltage of the direct current bus in the third time period to obtain a second voltage value.

The decoding chip 80 is connected to the direct current bus and is configured to demodulate the modulated signal to obtain a demodulated signal and extract the state parameter of the photovoltaic panel 30 from the demodulated signal to obtain the voltage state parameter of the photovoltaic panel 30, the temperature state parameter of the photovoltaic panel 30 and the position state parameter of the photovoltaic panel 30 and the like. In this way, the state parameter of the photovoltaic panel 30 of the photovoltaic device is transmitted to the control device through the direct current bus, thereby realizing direct communication between the photovoltaic device and the control device.

The second controller 90 is connected to the second sensor 70 and the decoding chip 80 and is configured to determine, based on the output signal of the direct current bus, whether the state parameter of the photovoltaic panel is successfully transmitted to the control device to obtain a determination result. In an example, it is determined whether a difference between the first voltage value and the second voltage value is greater than a preset threshold. If the difference between the first voltage value and the second voltage value is greater than the preset threshold, it is determined that the state parameter of the photovoltaic panel is not successfully transmitted to the control device, and if the difference between the first voltage value and the second voltage value is less than or equal to the preset threshold, it is determined that the state parameter of the photovoltaic panel is successfully transmitted to the control device.

The upper computer 100 is connected to the second controller 90 and is configured to receive the determination result and monitor a state of the photovoltaic panel based on the determination result. After the second controller 90 determines, based on the output voltage of the direct current bus, whether the state parameter of the photovoltaic panel is successfully transmitted to the control device, the operating state of the photovoltaic panel 30 is monitored. The upper computer 100 receives the determination result that the state parameter of the photovoltaic panel 30 is not successfully transmitted to the control device, or the determination result that the state parameter of the photovoltaic panel 30 is successfully transmitted to the control device. The upper computer 100 also receives the information collected by the second sensor 70 and the information collected by the demodulator, and further displays the information. The upper computer 100 monitors the operating state of the photovoltaic panel 30 based on the determination result. In a case where the upper computer 100 receives the determination result that the state parameter of the photovoltaic panel is not successfully transmitted to the control device, the upper computer 100 displays information that the state parameter of the photovoltaic panel 30 is not successfully transmitted to the control device 20. In a case where the upper computer 100 receives the determination result that the state parameter of the photovoltaic panel is successfully transmitted to the control device, the upper computer 100 displays information that the state parameter of the photovoltaic panel is successfully transmitted to the control device. Optionally, the upper computer 100 displays the information collected by the second sensor 70 and the information collected by the decoding chip 80, and monitors the operating state of the photovoltaic panel 30 in real time, such that the management person can know in real time whether the state parameter of the photovoltaic panel 30 is within a normal range of the state parameter, and control the photovoltaic electrical system timely in a case where the photovoltaic electrical system operates abnormally, thereby avoiding failure of the photovoltaic electrical system and preventing further deterioration of a fault, and thus achieving better maintenance of the photovoltaic electrical system. The upper computer 100 may further control the operating state of the photovoltaic panel based on the state parameter of the photovoltaic panel 30, such that the photovoltaic panel 30 outputs a normal state parameter, thereby improving monitorability of the photovoltaic panel 30, and ensuing the safe, stable and reliable operation of the photovoltaic panel 30.

The control device further includes an inverter 110, which is connected to the second controller 100, and is connected to the photovoltaic panel 30 through two direct current buses. The inverter 110 converts direct current power in the direct current bus into alternating current power and receives the information collected by the second sensor 70 and the information collected by the second controller 90 as well as the determination result determined by the second controller 90 on the information collected by the second sensor 70 and the information collected by the second controller 90, and outputs the information through a three-way alternating current, thereby performing the communication between the photovoltaic device and the control device based on a direct current power line carrier wave, thus achieving the communication between the photovoltaic device and the control device and improving the quality of the communication between the photovoltaic device and the control device.

The system for detecting the operating state of the photovoltaic panel outputs the state parameter of the photovoltaic panel through the photovoltaic panel; detects the state parameter of the photovoltaic panel through the first sensor; receives the state parameter of the photovoltaic panel through the first controller; modulates the state parameter of the photovoltaic panel through the modulation chip to obtain the modulated signal, and loads the modulated signal onto the direct current bus; detects the output signal of the direct current bus through the second sensor; demodulates the demodulated signal through the decoding chip to obtain the state parameter of the photovoltaic panel; determines, through the second controller whether the state parameter of the photovoltaic panel is successfully transmitted to the control device based on the output voltage of the direct current bus; receives, through the upper computer, the determination result and monitors the state of the photovoltaic panel based on the determination result; and receives, through the inverter, the information collected by the second sensor 70 and the information collected by the second controller 90 as well as the determination result determined by the second controller 90 on the information collected by the second sensor 70 and the information collected by the second controller 90, and outputs the information through a three-way alternating current. In this way, the communication between the photovoltaic device and the control device is achieved, improving the quality of the communication between the photovoltaic device and the control device.

A method for detecting an operating state of a photovoltaic panel is further provided according to the present disclosure.

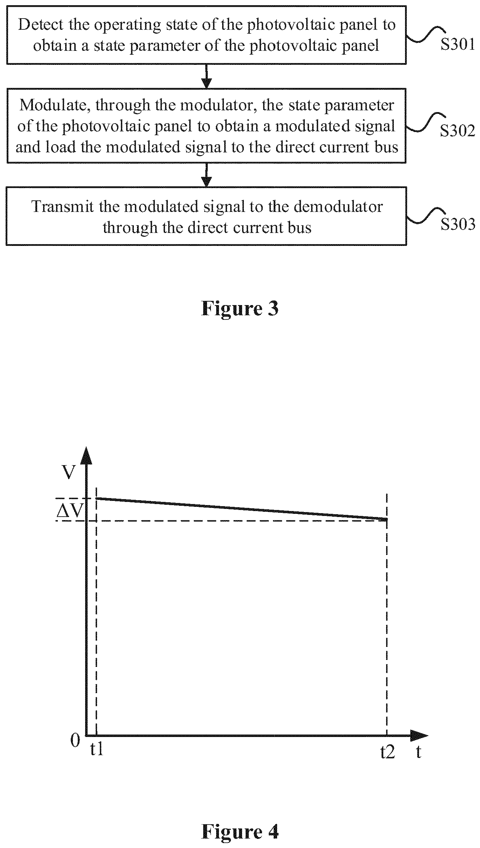

Figure 3 is a flowchart of a method for detecting an operating state of a photovoltaic panel according to an embodiment of the present disclosure. As shown in Figure 3, the communication method based on the photovoltaic panel includes the following steps S301 to S303.

In step S301, the operating state of the photovoltaic panel is detected to obtain a state parameter of the photovoltaic panel.

The photovoltaic panel is arranged in a photovoltaic electrical system. The photovoltaic electrical system includes a photovoltaic device and a control device. The photovoltaic device includes the photovoltaic panel and a modulator. The control device includes a demodulator. The photovoltaic device is connected to the control device via a direct current bus. The photovoltaic electrical system may be a photovoltaic air conditioning system, a solar water heater or other electrical system provided with the photovoltaic panel. The photovoltaic panel, which is a solar panel, provides continuous electrical energy for the photovoltaic electrical system utilizing light energy, such that the photovoltaic electrical system operates reliably, stably and continuously. The photovoltaic electrical system includes a photovoltaic device. The photovoltaic device includes a photovoltaic panel and a modulator. The modulator modulates the state parameter of the photovoltaic panel through a modulation chip. The detecting the state parameter of the photovoltaic panel includes, for example, detecting the voltage state parameter of the photovoltaic panel, the temperature state parameter of the photovoltaic panel and the position state parameter of the photovoltaic panel in the operation state. Optionally, the modulator detects the voltage state parameter of the photovoltaic panel through a voltage sensor, detects the temperature state parameter of the photovoltaic panel through a temperature sensor, and detects the position state parameter of the photovoltaic panel through a position sensor.

In step S302, the modulator modulates the state parameter of the photovoltaic panel to obtain a modulated signal, and loads the modulated signal onto the direct current bus.

After the state parameter of the photovoltaic panel is detected, the state parameter of the photovoltaic panel is received, and the photovoltaic panel is controlled based on the state parameter of the photovoltaic panel. For example, the photovoltaic device includes a first controller. The voltage state parameter, the temperature state parameter and the position state parameter of the photovoltaic panel are received through the first controller. The position of the photovoltaic panel may be controlled based on the position state parameter of the photovoltaic panel, to adjust a position state of the photovoltaic panel, such that the photovoltaic panel converts light energy into electrical energy in an effective area, to make the photovoltaic electrical system operate normally. After receiving the state parameter of the photovoltaic panel, the state parameter of the photovoltaic panel is modulated to obtain a modulated signal, that is, the state parameter of the photovoltaic panel is converted into a digital modulated signal suitable for channel transmission, and the modulated signal is loaded onto the direct current bus. Optionally, the photovoltaic device modulates the state parameter of the photovoltaic panel through the modulation chip to obtain the modulated signal, and loads the state parameter of the photovoltaic panel onto the direct current bus, thereby improving the power efficiency of the photovoltaic electrical system, and improving safety and reliability of the photovoltaic electrical system.

In step S303, the modulated signal is transmitted to the demodulator through the direct current bus.

A carrier wave, which is a radio wave with a specific frequency, is used to transmit information. The modulated signal may be loaded onto the carrier signal and transmitted via a carrier wave. The carrier signal is loaded onto the direct current bus, and the modulated signal is transmitted to the demodulator via the carrier signal. The demodulator receives the modulated signal based on a frequency of the carrier wave and demodulates the modulated signal to obtain a demodulated signal. That is, the modulator restores the received modulated signal to a digital baseband signal, which carries the state parameter of the photovoltaic panel, such as the voltage state parameter, the temperature state parameter and the position state parameter of the photovoltaic panel.

After the modulated signal is transmitted to the demodulator through the direct current bus, the output voltage of the direct current bus is detected. It is determined, based on the output voltage of the direct current bus, whether the state parameter of the photovoltaic panel is successfully transmitted to the control device, to obtain a determination result. The determination result is transmitted to an upper computer. The upper computer monitors the state of the photovoltaic panel based on the determination result. In an example, the control device includes a second controller. After the modulated signal is transmitted to the demodulator through the direct current bus, it is determined, through the second controller whether the state parameter of the photovoltaic panel is successfully transmitted to the control device based on the output voltage of the direct current bus, to obtain the determination result. The upper computer receives the determination result that the state parameter of the photovoltaic panel is not successfully transmitted to the control device, or the determination result that the state parameter of the photovoltaic panel is successfully transmitted to the control device. The upper computer also receives the information collected by the second sensor and the information collected by the demodulator. The upper computer displays the information collected by the second sensor and the information collected by the demodulator, and monitors the operating state of the photovoltaic panel in real time, such that the management person may better maintain the photovoltaic electrical system. The upper computer may further control the operating state of the photovoltaic panel based on the state parameter of the photovoltaic panel, such that the photovoltaic panel outputs a normal state parameter, thereby improving monitorability of the photovoltaic panel, and ensuing the safe, stable and reliable operation of the photovoltaic panel.

Figure 4 is a schematic diagram of a variation of a voltage of a direct current bus without a carrier wave according to an embodiment of the present disclosure. As shown in Figure 4, the output voltage of the photovoltaic panel changes with a strength of sunlight to which the photovoltaic panel is exposed, and t1 and t2 indicate different times when the photovoltaic panel is exposed to sunlight with different intensities, and ΔV indicates a voltage difference between an output voltage of the photovoltaic panel at time t1 and an output voltage of the photovoltaic panel at time t2. The instability of the output voltage of the photovoltaic panel results in a difficulty for the carrier wave of the direct current bus to transmit the modulated signal. However, the output voltage of the photovoltaic panel changes smoothly, and generally has no step. In a case of a short time period between time t1 and time t2, the voltage difference ΔV may be processed to demodulate the modulated signal, to obtain a demodulated signal.

The cycle of the communication between the photovoltaic device and the control device is a preset cycle. The control device includes the upper computer. The preset cycle includes successive periods of a first time period, a second time period and a third time period. In the second time period, the modulated signal is loaded onto the direct current bus or the modulated signal is demodulated. Preferably, the detecting the output voltage of the direct current bus includes: detecting the output voltage of the direct current bus in the first time period to obtain a first voltage value; detecting the output voltage of the direct current bus in the third time period to obtain a second voltage value. The determining, based on the output voltage of the direct current bus, whether the output voltage of the photovoltaic panel is successfully transmitted to the control device includes: determining whether a difference between the first voltage value and the second voltage value is greater than a preset threshold; determining, if the difference between the first voltage value and the second voltage value is greater than the preset threshold value, that the state parameter of the photovoltaic panel is not successfully transmitted to the control device; and determining, if the difference between the first voltage value and the second voltage value is less than or equal to the preset threshold, that the state parameter of the photovoltaic panel is successfully transmitted to the control device.

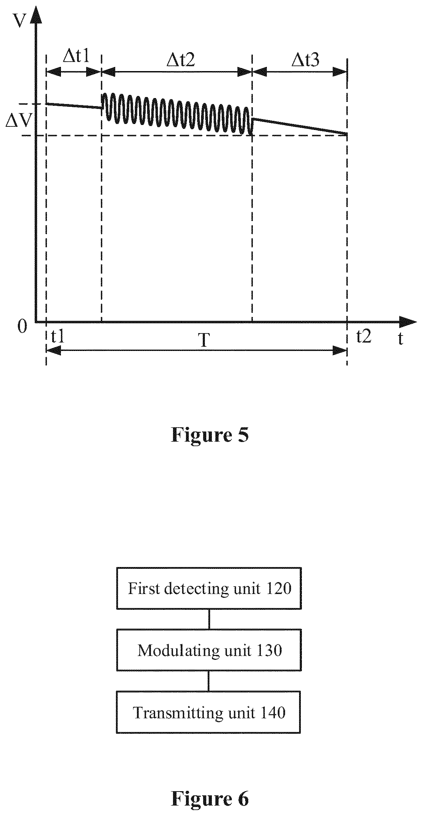

Figure 5 is a schematic diagram of a variation of a voltage of a direct current bus with a carrier wave according to an embodiment of the present disclosure. As shown in Figure 5, the photovoltaic device communicates with the control device to achieve information transmission between the photovoltaic device and the control device, which includes a transmission of the state parameter of the photovoltaic panel. The cycle of the communication between the photovoltaic device and the control device is a preset cycle T. Due to the ΔV, an abnormal detection in signal demodulation may be caused in a case where the carrier signal is loaded in all the cycle of the communication. Therefore, the preset cycle T is set to be sufficiently short. The preset cycle T includes successive periods of a first time period Δt1, a second time period Δt2 and a third time period Δt3. The voltage of the direct current bus is detected in the first time period Δt1, to obtain a first voltage value, that is, a fundamental wave voltage VI of a direct current power line carrier wave is detected in a reference voltage sampling time period Δt1. The modulated signal is loaded onto the direct current bus in the second time period Δt2, or the modulated signal is demodulated in the second time period Δt2, that is, in the carrier time period Δt2, the modulated signal is loaded onto the direct current bus or the modulated signal is demodulated. The voltage of the direct current bus is detected in the third time period Δt3 to obtain a second voltage value V2, that is, after the information transmission between the photovoltaic device and the control device is completed, the voltage V2 of the direct current bus is detected in the reference voltage checking time period Δt3. It is determined whether the difference ΔV between the first voltage value VI and the second voltage value V2 is greater than a preset threshold. If the difference ΔV between the first voltage value VI and the second voltage value V2 is greater than a preset threshold, it is determined that the state parameter of the photovoltaic panel is not successfully transmitted to the control device in the preset cycle, and the communication between the photovoltaic device and the control device is failed. If the difference ΔV between the first voltage value VI and the second voltage value V2 is less than or equal to the preset threshold value, it is determined that the state parameter of the photovoltaic panel is successfully transmitted to the control device in the preset cycle, and the communication between the photovoltaic device and the control device is successful.

Preferably, the photovoltaic electrical system in this embodiment is a photovoltaic air conditioning system.

The photovoltaic air conditioning system includes a photovoltaic device and a control device. The photovoltaic device includes a photovoltaic panel and a modulator. The control device includes a modulator. The photovoltaic device of the photovoltaic air conditioning system is connected to the control device of the photovoltaic air conditioning system via a direct current bus for communication. A state parameter of the photovoltaic panel is detected, the state parameter of the photovoltaic panel is modulated to obtain a modulated signal, and the modulated signal is loaded onto the direct current bus, where the modulated signal carries the state parameter of the photovoltaic panel. The modulator of the photovoltaic air conditioning system includes a first sensor, a first controller and a modulation chip. Preferably, the state parameter of the photovoltaic panel is detected through the first sensor. The first sensor includes a voltage sensor, a position sensor and a temperature sensor. The voltage sensor is configured to detect a voltage signal state parameter of the photovoltaic panel in the operation state. The position sensor is configured to detect a position state parameter of the photovoltaic panel in the operation state. The temperature sensor is configured to detect a temperature state parameter of the photovoltaic panel in the operation state. The first controller receives and processes the voltage state parameter, the position state parameter and the temperature state parameter of the photovoltaic panel detected by the first sensor, and timely adjusts a position of the photovoltaic panel based on the position state parameter of the photovoltaic panel detected by the first sensor. The modulation chip loads the operating parameter of the photovoltaic panel and the like onto the direct current bus.

After the modulator of the photovoltaic air conditioning system modulates a signal of the photovoltaic panel to obtain a modulated signal, and loads the modulated signal onto the direct current bus, the modulated signal is transmitted to the demodulator through the direct current bus. Preferably, the demodulator is configured to demodulate the modulated signal, to obtain a demodulated signal. The demodulator includes a second sensor, a second controller, a decoding chip and an upper computer. After the modulated signal is loaded onto the direct current bus, an output signal of the direct current bus is detected. For example, the second sensor is a voltage sensor, and the output voltage at an end of the direct current bus is detected by the voltage sensor. The modulated signal is demodulated through the decoding chip to obtain the demodulated signal, and the state parameter of the photovoltaic panel is extracted from the demodulated signal. A processing is performed based on the output voltage of the direct current bus and the state parameter of the photovoltaic panel, the output voltage of the direct current bus and the communication information may be processed by the second controller to obtain processing information. The upper computer receives the processing information and monitors the operating state of the photovoltaic panel based on the processing information.

In an embodiment of the method for detecting the operating state of the photovoltaic panel, the photovoltaic panel is arranged in the photovoltaic electrical system. The photovoltaic electrical system includes the photovoltaic device and the control device. The photovoltaic device includes the photovoltaic panel and the modulator. The control device includes the demodulator. The modulator is connected to the control device via the direct current bus. The operating state of the photovoltaic panel is detected to obtain the state parameter of the photovoltaic panel. The state parameter of the photovoltaic panel is modulated through the modulator to obtain the modulated signal, and the modulated signal is loaded onto the direct current bus. The modulated signal is transmitted to the demodulator via the direct current bus. The demodulator is configured to demodulate the modulated signal to obtain the demodulated signal, where the demodulated signal carries the state parameter of the photovoltaic panel. In this way, the quality of the communication between the photovoltaic device and the control device is improved.

It should be noted that the steps shown in the flowchart of the drawings may be performed in a computer system such as a set of computer-executable instructions, and although the logical sequence is shown in the flowchart, in some cases the illustrated or described steps may be performed in a different order.

An apparatus for detecting an operating state of a photovoltaic panel is further provided according to the present disclosure.

Figure 6 is a schematic diagram of an apparatus for detecting an operating state of a photovoltaic panel according to an embodiment of the present disclosure. As shown in Figure 6, the apparatus for detecting the operating state of the photovoltaic panel includes a detecting unit 120, a modulating unit 130 and a transmitting unit 140.

The photovoltaic panel is arranged in a photovoltaic electrical system. The photovoltaic electrical system includes a photovoltaic device and a control device. The photovoltaic device includes the photovoltaic panel and a modulator. The control device includes a demodulator. The modulator is connected to the control device via a direct current bus.

The first detecting unit 120 is configured to detect the operating state of the photovoltaic panel to obtain the state parameter of the photovoltaic panel.

The modulating unit 130 is configured to modulate the state parameter of the photovoltaic panel through the modulator, to obtain a modulated signal, and loads the modulated signal onto the direct current bus.

The transmitting unit 140 is configured to transmit the modulated signal to a demodulator via the direct current bus. The demodulator is configured to demodulate the modulated signal to obtain the state parameter of the photovoltaic panel.

The apparatus for detecting the operating state of the photovoltaic panel further includes a second detecting unit and a determining unit. The second detecting unit is configured to detect an output voltage of the direct current bus after the modulated signal is transmitted to the demodulator via the direct current bus. The determining unit is configured to determine, based on the output voltage of the direct current bus, whether the state parameter of the photovoltaic panel is successfully transmitted to the control device, to obtain a determination result, and transmits the determination result to an upper computer. The upper computer is configured to monitor a state of the photovoltaic panel based on the determination result.

A cycle of the communication between the photovoltaic device and the control device is a preset cycle. The control device includes the upper computer. The preset cycle includes successive periods of a first time period, a second time period and a third time period. In the second time period, the modulated signal is loaded onto the direct current bus or the demodulated signal is demodulated. The second detecting unit includes a first detecting module and a second detecting module. The first detecting module is configured to detect an output voltage of the direct current bus in the first time period to obtain a first voltage value. The second detection module is configured to detect an output voltage of the direct current bus in the third time period to obtain a second voltage value. The determining unit includes a determining module, a first determining module and a second determining module. The determining module is configured to determine whether a difference between the first voltage value and the second voltage value is greater than a preset threshold. The first determining module is configured to determine, if the difference between the first voltage value and the second voltage value is greater than a preset threshold, that the state parameter of the photovoltaic panel is not successfully transmitted to the control device. The second determining module is configured to determine, if the difference between the first voltage value and the second voltage value is less than or equal to the preset threshold, that the state parameter of the photovoltaic panel is successfully transmitted to the control device.

The apparatus for detecting the operating state of the photovoltaic panel detects the operating state of the photovoltaic panel through the first detecting unit, to obtain the state parameter of the photovoltaic panel; modulates the state parameter of the photovoltaic panel through the modulator of the modulating unit, to obtain a modulated signal, and loads the modulated signal onto the direct current bus; and transmits the modulated signal to the demodulator by the transmitting unit via the direct current bus, thereby improving the quality of the communication between the photovoltaic device and the control device.

A photovoltaic electrical system is further provided according to an embodiment of the disclosure. It should be noted that the photovoltaic electrical system includes the apparatus for detecting the operating state of the photovoltaic panel and the system for detecting the operating state of the photovoltaic panel according to the embodiments of the present disclosure. The communication between the photovoltaic device of the photovoltaic electrical system and the control device of the photovoltaic electrical system is performed based on a medium voltage signal, and the communication between the photovoltaic device and the control device is achieved with a direct current power line wave-carrying method. Optionally, the communication between the photovoltaic device and the control device is performed by loading a carrier wave onto the direct current line as a transmission medium for the communication between the photovoltaic device and the control device, thereby achieving data transmission and information exchange between the photovoltaic device and the control device. In an example, the detecting and processing information of the photovoltaic panel in the photovoltaic device include: detecting and processing the state parameter of the photovoltaic panel; detecting a fundamental wave voltage of a carrier signal on the direct current bus; modulating the state parameter of the photovoltaic panel to obtain a modulated signal, and loading the modulated signal onto the direct current bus; detecting a voltage on the direct current bus after the modulated signal is loaded onto the direct current bus; determining whether the communication between the photovoltaic panel and the control device is normal based on a difference between the fundamental wave voltage of the carrier signal on the direct current bus and the voltage on the direct current bus after the modulated signal is loaded onto the direct current bus. After the modulated signal is loaded onto the direct current bus, the output voltage of the direct current bus is detected. The modulated signal is demodulated through the demodulator to obtain a demodulated signal. After the demodulated signal is obtained, the output voltage of the direct current bus is detected. It is determined whether the communication between the photovoltaic device and the control device is normal based on a difference between the output voltages of the direct current bus before the demodulation and after the demodulation. In this way, the communication between the photovoltaic device and the control device is achieved and the state parameter of the photovoltaic panel of the photovoltaic device is transmitted to the control device, thereby improving monitorability of the photovoltaic panel, reducing a cost in wiring a communication bus between the photovoltaic device and the control device, and improving a quality of the communication between photovoltaic device and control device in the photovoltaic electrical systems.

Apparently, those skilled in the art should understand that the modules or steps in the present disclosure described above may be implemented by a general-purpose computing apparatus, which may be integrated on a single computing apparatus or distributed over a network including multiple computing apparatus. Alternatively, the modules or steps in the present disclosure may be implemented with program codes executable by a computing apparatus, such that the modules or steps in the present disclosure may be stored in a storage apparatus for execution by a computing apparatus, or separately implemented by various integrated circuit modules, or multiple of the modules or steps are implemented in a single integrated circuit module. Thus, the present disclosure is not limited to any specific combination of hardware and software.

## Claims

1. A method for detecting an operating state of a photovoltaic panel, wherein the photovoltaic panel is arranged in a photovoltaic electrical system, the photovoltaic electrical system comprises a photovoltaic device and a control device, the photovoltaic device comprises the photovoltaic panel and a modulator, the control device comprises a demodulator, the photovoltaic device is connected to the control device via a direct current bus, the method comprises:
detecting the operating state of the photovoltaic panel to obtain a state parameter of the photovoltaic panel;
modulating, through the modulator, the state parameter of the photovoltaic panel to obtain a modulated signal, and loading the modulated signal to the direct current bus; and
transmitting the modulated signal to the demodulator through the direct current bus, wherein the demodulator is configured to demodulate the modulated signal to obtain the state parameter of the photovoltaic panel;
wherein a cycle of communication between the photovoltaic device and the control device is a preset cycle, and the preset cycle comprises successive periods of a first time period, a second time period and a third time period, wherein in the second time period, the modulated signal is loaded onto the direct current bus or the modulated signal is demodulated; and
wherein after transmitting the modulated signal to the demodulator through the direct current bus, the method further comprises:
detecting the output voltage of the direct current bus in the first time period to obtain a first voltage value;
detecting the output voltage of the direct current bus in the third time period to obtain a second voltage value;
determining whether a difference between the first voltage value and the second voltage value is greater than a preset threshold;
determining, if the difference between the first voltage value and the second voltage value is greater than the preset threshold, that the state parameter of the photovoltaic panel is not successfully transmitted to the control device; and
determining, if the difference between the first voltage value and the second voltage value is less than or equal to the preset threshold, that the state parameter of the photovoltaic panel is successfully transmitted to the control device.

2. The method according to claim 1, wherein whether the state parameter of the photovoltaic panel is successfully transmitted to the control device is determined to obtain a determination result, the control device comprises an upper computer, and the method further comprises:
transmitting the determination result to the upper computer, wherein the upper computer is configured to monitor the state of the photovoltaic panel based on the determination result.

3. The method according to claim 1, wherein the detecting the state parameter of the photovoltaic panel comprises detecting any one or more of the following state parameters of the photovoltaic panel:
a voltage state parameter of the photovoltaic panel;
a position state parameter of the photovoltaic panel; and
a temperature state parameter of the photovoltaic panel.

4. The method according to claim 1, wherein after detecting the operating state of the photovoltaic panel, the method further comprises:
controlling a state of the photovoltaic panel based on the state parameter of the photovoltaic panel.

5. The method according to claim 1, wherein the photovoltaic electrical system is a photovoltaic air conditioning system.

6. An apparatus for detecting an operating state of a photovoltaic panel, the apparatus comprising the photovoltaic panel arranged in a photovoltaic electrical system, the photovoltaic electrical system comprises a photovoltaic device and a control device, the photovoltaic device comprises the photovoltaic panel and a modulator, the control device comprises a demodulator, and the photovoltaic device is connected to the control device via a direct current bus, the apparatus further comprises:
a first detecting unit, configured to detect the operating state of the photovoltaic panel to obtain a state parameter of the photovoltaic panel;
a modulating unit, configured to modulate, through the modulator, the state parameter of the photovoltaic panel to obtain a modulated signal, and load the modulated signal onto the direct current bus; and
a transmitting unit, configured to transmit the modulated signal to the demodulator via the direct current bus, wherein the demodulator is configured to demodulate the modulated signal to obtain the state parameter of the photovoltaic panel;
wherein a cycle of communication between the photovoltaic device and the control device is a preset cycle, and the preset cycle comprises successive periods of a first time period, a second time period and a third time period, wherein in the second time period, the modulated signal is loaded onto the direct current bus or the modulated signal is demodulated, and the apparatus further comprises:
a second detecting unit, configured to detect the output voltage of the direct current bus in the first time period to obtain a first voltage value, and detect the output voltage of the direct current bus in the third time period to obtain a second voltage value, after the modulated signal is transmitted to the demodulator through the direct current bus; and
a determining unit, configured to determine whether a difference between the first voltage value and the second voltage value is greater than a preset threshold, determine, if the difference between the first voltage value and the second voltage value is greater than the preset threshold, that the state parameter of the photovoltaic panel is not successfully transmitted to the control device, and determine, if the difference between the first voltage value and the second voltage value is less than or equal to the preset threshold, that the state parameter of the photovoltaic panel is successfully transmitted to the control device.

7. The apparatus according to claim 6, wherein whether the state parameter of the photovoltaic panel is successfully transmitted to the control device is determined as the determination result, and
the determining unit is further configured to transmit the determination result to an upper computer, wherein the upper computer is configured to monitor a state of the photovoltaic panel based on the determination result.

8. A system for detecting an operating state of a photovoltaic panel, the system comprising the photovoltaic panel arranged in a photovoltaic electrical system, the photovoltaic electrical system comprises a photovoltaic device and a control device, the photovoltaic device comprises the photovoltaic panel and a modulator, the control device comprises a demodulator, and the photovoltaic device is connected to the control device via a direct current bus, and wherein
the photovoltaic device is configured to detect the operating state of the photovoltaic panel to obtain a state parameter of the photovoltaic panel, modulate the state parameter of the photovoltaic panel through the modulator to obtain a modulated signal, and load the modulated signal onto the direct current bus, and
the control device is configured to detect the modulated signal outputted from the direct current bus and demodulate the modulated signal through the demodulator to obtain the state parameter of the photovoltaic panel;
wherein a cycle of communication between the photovoltaic device and the control device is a preset cycle, which comprises successive periods of a first time period, a second time period and a third time period, wherein in the second time period, the modulated signal is loaded onto the direct current bus or the modulated signal is demodulated, and the system further comprises:
a voltage sensor, configured to detect, in the first time period, the output voltage of the direct current bus to obtain a first voltage value, and detect, in the third time period, the output voltage of the direct current bus to obtain a second voltage value;
a second controller, configured to: determine whether a difference between the first voltage value and the second voltage value is greater than a preset threshold; determine, if the difference between the first voltage value and the second voltage value is greater than the preset threshold, that the state parameter of the photovoltaic panel is not successfully transmitted to the control device; and determine, if the difference between the first voltage value and the second voltage value is less than or equal to the preset threshold, that the state parameter of the photovoltaic panel is successfully transmitted to the control device.

9. The system according to claim 8, wherein the photovoltaic device further comprises:
a first sensor, configured to detect the operating state of the photovoltaic panel to obtain the state parameter of the photovoltaic panel; and
a first controller, configured to receive the state parameter of the photovoltaic panel and control the photovoltaic panel based on the state parameter of the photovoltaic panel.

10. The system according to claim 9, wherein the first sensor comprises any one or more of the following sensors:
a voltage sensor, configured to detect a voltage state parameter of the photovoltaic panel;
a position sensor, configured to detect a position state parameter of the photovoltaic panel, wherein the first controller is configured to adjust a position of the photovoltaic panel based on a signal relating to a position of the photovoltaic panel; and
a temperature sensor, configured to detect a temperature state parameter of the photovoltaic panel.

11. The system according to claim 8, wherein whether the state parameter of the photovoltaic panel is successfully transmitted to the control device is determined to obtain a determination result, and the control device further comprises:
an upper computer, configured to receive the determination result, and monitor a state of the photovoltaic panel based on the determination result.

12. A photovoltaic electrical system, comprising the apparatus for detecting an operating state of a photovoltaic panel according to claim 6 or 7, or the system for detecting an operating state of a photovoltaic panel according to any one of claims 8 to 11.

## Patentansprüche

1. Verfahren zum Erkennen eines Betriebszustands einer Photovoltaikplatte, wobei die Photovoltaikplatte in einer elektrischen Photovoltaikanlage angeordnet ist, wobei die elektrische Photovoltaikanlage ein Photovoltaikgerät und ein Steuergerät umfasst, das Photovoltaikgerät die Photovoltaikplatte und einen Modulator umfasst, das Steuergerät einen Demodulator umfasst, das Photovoltaikgerät über einen Gleichstrombus an das Steuergerät angeschlossen ist und das Verfahren umfasst:
Erkennen des Betriebszustands der Photovoltaikplatte, um einen Zustandsparameter der Photovoltaikplatte zu ermitteln,
Modulieren des Zustandsparameters der Photovoltaikplatte über den Modulator, um ein moduliertes Signal zu erhalten, und Laden des modulierten Signals in den Gleichstrombus; und
Übertragen des modulierten Signals an den Demodulator über den Gleichstrombus, wobei der Demodulator zum Demodulieren des modulierten Signals konfiguriert ist, um den Zustandsparameter der Photovoltaikplatte zu erhalten,
wobei ein Kommunikationszyklus zwischen dem Photovoltaikgerät und dem Steuergerät ein voreingestellter Zyklus ist und der voreingestellte Zyklus aufeinanderfolgende Zeiträume umfasst, die aus einem ersten Zeitraum, einem zweiten Zeitraum und einem dritten Zeitraum bestehen, wobei im zweiten Zeitraum das modulierte Signal auf den Gleichstrombus geladen wird oder das modulierte Signal demoduliert wird, und
wobei das Verfahren im Anschluss an das Übertragen des modulierten Signals an den Demodulator über den Gleichstrombus ferner umfasst:
Erkennen der Ausgangsspannung des Gleichstrombus im ersten Zeitraum, um einen ersten Spannungswert zu erhalten,
Erkennen der Ausgangsspannung des Gleichstrombus im dritten Zeitraum, um einen zweiten Spannungswert zu erhalten,
Ermitteln, ob ein Unterschied zwischen dem ersten Spannungswert und dem zweiten Spannungswert eine voreingestellte Schwelle übersteigt,
wenn der Unterschied zwischen dem ersten Spannungswert und dem zweiten Spannungswert die voreingestellte Schwelle übersteigt: Feststellen, dass der Zustandsparameter der Photovoltaikplatte an das Steuergerät nicht erfolgreich übertragen wird, und
wenn der Unterschied zwischen dem ersten Spannungswert und dem zweiten Spannungswert kleiner oder gleich der voreingestellten Schwelle ist: Feststellen, dass der Zustandsparameter der Photovoltaikplatte an das Steuergerät erfolgreich übertragen wird.

2. Verfahren nach Anspruch 1, wobei ermittelt wird, ob der Zustandsparameter der Photovoltaikplatte an das Steuergerät erfolgreich übertragen wird, um ein Ermittlungsergebnis zu erhalten, das Steuergerät einen Oberrechner umfasst und das Verfahren ferner umfasst:
Übertragen des Ermittlungsergebnisses an den Oberrechner, wobei der Oberrechner derart konfiguriert ist, dass er den Zustand der Photovoltaikplatte anhand des Ermittlungsergebnisses überwacht.

3. Verfahren nach Anspruch 1, wobei das Erkennen des Zustandsparameters der Photovoltaikplatte umfasst: Erkennen mindestens eines folgender Zustandsparameter der Photovoltaikplatte:
ein Spannungszustandsparameter der Photovoltaikplatte,
ein Positionszustandsparameter der Photovoltaikplatte und
ein Temperaturzustandsparameter der Photovoltaikplatte.

4. Verfahren nach Anspruch 1, wobei im Anschluss an das Erkennen des Betriebszustands der Photovoltaikplatte das Verfahren ferner umfasst:
Steuern eines Zustands der Photovoltaikplatte aufgrund des Zustandsparameters der Photovoltaikplatte.

5. Verfahren nach Anspruch 1, wobei die elektrische Photovoltaikanlage eine photovoltaische Klimaanlage ist.

6. Vorrichtung zum Erkennen eines Betriebszustands einer Photovoltaikplatte, wobei die Vorrichtung umfasst:
die in einer elektrischen Photovoltaikanlage angeordnete Photovoltaikplatte, wobei die elektrische Photovoltaikanlage ein Photovoltaikgerät und ein Steuergerät umfasst, das Photovoltaikgerät die Photovoltaikplatte und einen Modulator umfasst, das Steuergerät einen Demodulator umfasst und das Photovoltaikgerät über einen Gleichstrombus an das Steuergerät angeschlossen ist und die Vorrichtung ferner umfasst:
eine erste Erkennungseinheit, die zum Erkennen des Betriebszustands der Photovoltaikplatte konfiguriert ist, um einen Zustandsparameter der Photovoltaikplatte zu ermitteln,
eine Modulationseinheit, die konfiguriert ist zum Modulieren des Zustandsparameters der Photovoltaikplatte über den Modulator, um ein moduliertes Signal zu erhalten, und zum Laden des modulierten Signals in den Gleichstrombus und
eine Sendeeinheit, die zum Übertragen des modulierten Signals an den Demodulator über den Gleichstrombus konfiguriert ist, wobei der Demodulator zum Demodulieren des modulierten Signals konfiguriert ist, um den Zustandsparameter der Photovoltaikplatte zu erhalten,
wobei ein Kommunikationszyklus zwischen dem Photovoltaikgerät und dem Steuergerät ein voreingestellter Zyklus ist und der voreingestellte Zyklus aufeinanderfolgende Zeiträume umfasst, die aus einem ersten Zeitraum, einem zweiten Zeitraum und einem dritten Zeitraum bestehen, wobei im zweiten Zeitraum das modulierte Signal auf den Gleichstrombus geladen wird oder das modulierte Signal demoduliert wird, und die Vorrichtung ferner umfasst:
eine zweite Erkennungseinheit, die konfiguriert ist zum Erkennen der Ausgangsspannung des Gleichstrombus im ersten Zeitraum, um einen ersten Spannungswert zu erhalten, zum Erkennen der Ausgangsspannung des Gleichstrombus im dritten Zeitraum, um einen zweiten Spannungswert zu erhalten, nachdem das modulierte Signal über den Gleichstrombus an den Demodulator übertragen wird, und
eine Ermittlungseinheit, die konfiguriert ist zum Ermitteln, ob ein Unterschied zwischen dem ersten Spannungswert und dem zweiten Spannungswert eine voreingestellte Schwelle übersteigt, zum Feststellen, dass der Zustandsparameter der Photovoltaikplatte an das Steuergerät nicht erfolgreich übertragen wird, wenn der Unterschied zwischen dem ersten Spannungswert und dem zweiten Spannungswert die voreingestellte Schwelle übersteigt, und zum Feststellen, dass der Zustandsparameter der Photovoltaikplatte an das Steuergerät erfolgreich übertragen wird, wenn der Unterschied zwischen dem ersten Spannungswert und dem zweiten Spannungswert kleiner oder gleich der voreingestellten Schwelle ist.

7. Vorrichtung nach Anspruch 6, wobei als Ermittlungsergebnis ermittelt wird, ob der Zustandsparameter der Photovoltaikplatte erfolgreich an das Steuergerät übertragen wird, und
die Ermittlungseinheit ferner zum Übertragen des Ermittlungsergebnisses an einen Oberrechner konfiguriert ist, wobei der Oberrechner derart konfiguriert ist, dass er den Zustand der Photovoltaikplatte anhand des Ermittlungsergebnisses überwacht.

8. System zur Erkennung eines Betriebszustands einer Photovoltaikplatte,
wobei das System die in einer elektrischen Photovoltaikanlage angeordnete Photovoltaikplatte umfasst, wobei die elektrische Photovoltaikanlage ein Photovoltaikgerät und ein Steuergerät umfasst, das Photovoltaikgerät die Photovoltaikplatte und einen Modulator umfasst, das Steuergerät einen Demodulator umfasst, das Photovoltaikgerät über einen Gleichstrombus an das Steuergerät angeschlossen ist und wobei
das Photovoltaikgerät konfiguriert ist zum Erkennen des Betriebszustands der Photovoltaikplatte, um einen Zustandsparameter der Photovoltaikplatte zu erhalten, zum Modulieren des Zustandsparameters der Photovoltaikplatte über einen Modulator, um ein moduliertes Signal zu erhalten, und zum Laden des modulierten Signals auf den Gleichstrombus, und
das Steuergerät zum Erkennen des vom Gleichstrombus ausgegebenen modulierten Signals und zum Demodulierten des modulierten Signals durch den Demodulator konfiguriert ist, um den Zustandsparameter der Photovoltaikplatte zu erhalten,
wobei ein Kommunikationszyklus zwischen dem Photovoltaikgerät und dem Steuergerät ein voreingestellter Zyklus ist, der voreingestellte Zyklus aufeinanderfolgende Zeiträume umfasst, die aus einem ersten Zeitraum, einem zweiten Zeitraum und einem dritten Zeitraum bestehen, wobei im zweiten Zeitraum das modulierte Signal auf den Gleichstrombus geladen wird oder das modulierte Signal demoduliert wird, und das System ferner umfasst:
einen Spannungssensor, der derart konfiguriert ist, dass er im ersten Zeitraum die Ausgangsspannung des Gleichstrombus erkennt, um einen ersten Spannungswert zu erhalten, und im dritten Zeitraum die Ausgangsspannung des Gleichstrombus erkennt, um einen zweiten Spannungswert zu erhalten,
eine zweite Steuerung, die konfiguriert ist zum Ermitteln, ob ein Unterschied zwischen dem ersten Spannungswert und dem zweiten Spannungswert eine voreingestellte Schwelle übersteigt, zum Feststellen, dass der Zustandsparameter der Photovoltaikplatte an das Steuergerät nicht erfolgreich übertragen wird, wenn der Unterschied zwischen dem ersten Spannungswert und dem zweiten Spannungswert die voreingestellte Schwelle übersteigt, und zum Feststellen, dass der Zustandsparameter der Photovoltaikplatte an das Steuergerät erfolgreich übertragen wird, wenn der Unterschied zwischen dem ersten Spannungswert und dem zweiten Spannungswert kleiner oder gleich der voreingestellten Schwelle ist.

9. System nach Anspruch 8, wobei das Photovoltaikgerät ferner umfasst: einen ersten Sensor, der zum Erkennen des Betriebszustands der Photovoltaikplatte konfiguriert ist, um den Zustandsparameter der Photovoltaikplatte zu ermitteln, und
eine erste Steuerung, die zum Empfangen des Zustandsparameters der Photovoltaikplatte und zu Steuerung der Photovoltaikplatte anhand des Zustandsparameters der Photovoltaikplatte konfiguriert ist.

10. System nach Anspruch 9, wobei der erste Sensor einen oder mehrere folgender Sensoren umfasst:
einen Spannungssensor, der zum Erkennen eines Spannungszustandsparameters der Photovoltaikplatte konfiguriert ist,
einen Positionssensor, der zum Erkennen eines Positionszustandsparameters der Photovoltaikplatte konfiguriert ist, wobei die erste Steuerung derart konfiguriert ist, dass sie eine Position der Photovoltaikplatte anhand eines eine Position der Photovoltaikplatte betreffenden Signals anpasst, und
einen Temperatursensor, der zum Erkennen eines Temperaturzustandsparameters der Photovoltaikplatte konfiguriert ist.

11. System nach Anspruch 8, wobei ermittelt wird, ob der Zustandsparameter der Photovoltaikplatte an das Steuergerät erfolgreich übertragen wird, um ein Ermittlungsergebnis zu erhalten, und das Steuergerät ferner umfasst:
einen Oberrechner, der zum Empfangen des Ermittlungsergebnisses und zum Überwachen eines Zustands der Photovoltaikplatte anhand des Ermittlungsergebnisses konfiguriert ist.

12. Elektrische Photovoltaikanlage, umfassend die Vorrichtung zum Erkennen eines Betriebszustands einer Photovoltaikplatte nach Anspruch 6 oder 7 oder das System zum Erkennen eines Betriebszustands einer Photovoltaikplatte nach einem der Ansprüche 8 - 11.

## Revendications

1. Procédé de détection d'un état de fonctionnement d'un panneau photovoltaïque, dans lequel le panneau photovoltaïque est agencé dans un système électrique photovoltaïque, dans lequel le système électrique photovoltaïque comprend un dispositif photovoltaïque et un dispositif de commande, le dispositif photovoltaïque comprend le panneau photovoltaïque et un modulateur, le dispositif de commande comprend un démodulateur, le dispositif photovoltaïque est connecté au dispositif de commande par l'intermédiaire d'un bus de courant continu, dans lequel le procédé comprend les étapes consistant à :
détecter l'état de fonctionnement du panneau photovoltaïque en vue d'obtenir un paramètre d'état du panneau photovoltaïque ;
moduler, par le biais du modulateur, le paramètre d'état du panneau photovoltaïque, en vue d'obtenir un signal modulé, et charger le signal modulé sur le bus de courant continu ; et
transmettre le signal modulé au démodulateur par le biais du bus de courant continu, dans lequel le démodulateur est configuré de manière à démoduler le signal modulé en vue d'obtenir le paramètre d'état du panneau photovoltaïque ;
dans lequel un cycle de communication entre le dispositif photovoltaïque et le dispositif de commande correspond à un cycle prédéfini, et le cycle prédéfini comprend des périodes successives d'une première période de temps, d'une deuxième période de temps et d'une troisième période de temps, dans lequel, dans la deuxième période de temps, le signal modulé est chargé sur le bus de courant continu ou le signal modulé est démodulé ; et
dans lequel, suite à la transmission du signal modulé au démodulateur par le biais du bus de courant continu, le procédé comprend en outre les étapes consistant à :
détecter la tension de sortie du bus de courant continu au cours de la première période de temps, en vue d'obtenir une première valeur de tension ;
détecter la tension de sortie du bus de courant continu au cours de la troisième période de temps, en vue d'obtenir une seconde valeur de tension ;
déterminer si une différence entre la première valeur de tension et la seconde valeur de tension est supérieure à un seuil prédéfini ;
déterminer, si la différence entre la première valeur de tension et la seconde valeur de tension est supérieure au seuil prédéfini, que le paramètre d'état du panneau photovoltaïque n'est pas transmis correctement au dispositif de commande ; et
déterminer, si la différence entre la première valeur de tension et la seconde valeur de tension est inférieure ou égale au seuil prédéfini, que le paramètre d'état du panneau photovoltaïque est transmis correctement au dispositif de commande.

2. Procédé selon la revendication 1, dans lequel il est déterminé si le paramètre d'état du panneau photovoltaïque est transmis correctement au dispositif de commande, en vue d'obtenir un résultat de détermination, dans lequel le dispositif de commande comprend un ordinateur supérieur, et le procédé comprend en outre l'étape consistant à :
transmettre le résultat de détermination à l'ordinateur supérieur, dans lequel l'ordinateur supérieur est configuré de manière à surveiller l'état du panneau photovoltaïque sur la base du résultat de détermination.

3. Procédé selon la revendication 1, dans lequel l'étape de détection du paramètre d'état du panneau photovoltaïque consiste à détecter un quelconque ou plusieurs des paramètres d'état du panneau photovoltaïque, à savoir :
un paramètre d'état de tension du panneau photovoltaïque ;
un paramètre d'état de position du panneau photovoltaïque ; et
un paramètre d'état de température du panneau photovoltaïque.

4. Procédé selon la revendication 1, dans lequel, suite à la détection de l'état de fonctionnement du panneau photovoltaïque, le procédé comprend en outre l'étape consistant à :
commander un état du panneau photovoltaïque sur la base du paramètre d'état du panneau photovoltaïque.

5. Procédé selon la revendication 1, dans lequel le système électrique photovoltaïque est un système de climatisation photovoltaïque.

6. Appareil pour détecter un état de fonctionnement d'un panneau photovoltaïque, l'appareil comprenant le panneau photovoltaïque agencé dans un système électrique photovoltaïque, dans lequel le système électrique photovoltaïque comprend un dispositif photovoltaïque et un dispositif de commande, le dispositif photovoltaïque comprend le panneau photovoltaïque et un modulateur, le dispositif de commande comprend un démodulateur, et le dispositif photovoltaïque est connecté au dispositif de commande par l'intermédiaire d'un bus de courant continu, dans lequel l'appareil comprend en outre :
une première unité de détection, configurée de manière à détecter l'état de fonctionnement du panneau photovoltaïque, en vue d'obtenir un paramètre d'état du panneau photovoltaïque ;
une unité de modulation, configurée de manière à moduler, par le biais du modulateur, le paramètre d'état du panneau photovoltaïque, en vue d'obtenir un signal modulé, et à charger le signal modulé sur le bus de courant continu ; et
une unité de transmission, configurée de manière à transmettre le signal modulé au démodulateur, par l'intermédiaire du bus de courant continu, dans lequel le démodulateur est configuré de manière à démoduler le signal modulé en vue d'obtenir le paramètre d'état du panneau photovoltaïque ;
dans lequel un cycle de communication entre le dispositif photovoltaïque et le dispositif de commande correspond à un cycle prédéfini, et le cycle prédéfini comprend des périodes successives d'une première période de temps, d'une deuxième période de temps et d'une troisième période de temps, dans lequel, au cours de la deuxième période de temps, le signal modulé est chargé sur le bus de courant continu ou le signal modulé est démodulé, et l'appareil comprend en outre :
une seconde unité de détection, configurée de manière à détecter la tension de sortie du bus de courant continu au cours de la première période de temps, en vue d'obtenir une première valeur de tension, et à détecter la tension de sortie du bus de courant continu au cours de la troisième période de temps, en vue d'obtenir une seconde valeur de tension, dès lors que le signal modulé a été transmis au démodulateur par le biais du bus de courant continu ; et
une unité de détermination, configurée de manière à déterminer si une différence entre la première valeur de tension et la seconde valeur de tension est supérieure à un seuil prédéfini, à déterminer, si la différence entre la première valeur de tension et la seconde valeur de tension est supérieure au seuil prédéfini, que le paramètre d'état du panneau photovoltaïque n'est pas transmis correctement au dispositif de commande, et à déterminer, si la différence entre la première valeur de tension et la seconde valeur de tension est inférieure ou égale au seuil prédéfini, que le paramètre d'état du panneau photovoltaïque est transmis correctement au dispositif de commande.

7. Appareil selon la revendication 6, dans lequel il est déterminé si le paramètre d'état du panneau photovoltaïque est transmis correctement au dispositif de commande, en tant que le résultat de détermination ; et
l'unité de détermination est en outre configurée de manière à transmettre le résultat de détermination à un ordinateur supérieur, dans lequel l'ordinateur supérieur est configuré de manière à surveiller un état du panneau photovoltaïque sur la base du résultat de détermination.

8. Système pour détecter un état de fonctionnement d'un panneau photovoltaïque, dans lequel le système comprend le panneau photovoltaïque agencé dans un système électrique photovoltaïque, le système électrique photovoltaïque comprend un dispositif photovoltaïque et un dispositif de commande, le dispositif photovoltaïque comprend le panneau photovoltaïque et un modulateur, le dispositif de commande comprend un démodulateur, et le dispositif photovoltaïque est connecté au dispositif de commande par l'intermédiaire d'un bus de courant continu, et dans lequel :
le dispositif photovoltaïque est configuré de manière à détecter l'état de fonctionnement du panneau photovoltaïque, en vue d'obtenir un paramètre d'état du panneau photovoltaïque, à moduler le paramètre d'état du panneau photovoltaïque par le biais du modulateur, en vue d'obtenir un signal modulé, et à charger le signal modulé sur le bus de courant continu ; et
le dispositif de commande est configuré de manière à détecter le signal modulé fourni en sortie à partir du bus de courant continu, et à démoduler le signal modulé par le biais du démodulateur, en vue d'obtenir le paramètre d'état du panneau photovoltaïque ;
dans lequel un cycle de communication entre le dispositif photovoltaïque et le dispositif de commande correspond à un cycle prédéfini, lequel comprend des périodes successives d'une première période de temps, d'une deuxième période de temps et d'une troisième période de temps, dans lequel, au cours de la deuxième période de temps, le signal modulé est chargé sur le bus de courant continu, ou le signal modulé est démodulé, et le système comprend en outre :
un capteur de tension, configuré de manière à détecter, au cours de la première période de temps, la tension de sortie du bus de courant continu, en vue d'obtenir une première valeur de tension, et à détecter, au cours de la troisième période de temps, la tension de sortie du bus de courant continu, en vue d'obtenir une seconde valeur de tension ;
un second contrôleur, configuré de manière à : déterminer si une différence entre la première valeur de tension et la seconde valeur de tension est supérieure à un seuil prédéfini ; déterminer, si la différence entre la première valeur de tension et la seconde valeur de tension est supérieure au seuil prédéfini, que le paramètre d'état du panneau photovoltaïque n'est pas transmis correctement au dispositif de commande ; et déterminer, si la différence entre la première valeur de tension et la seconde valeur de tension est inférieure ou égale au seuil prédéfini, que le paramètre d'état du panneau photovoltaïque est transmis correctement au dispositif de commande.

9. Système selon la revendication 8, dans lequel le dispositif photovoltaïque comprend en outre :
un premier capteur, configuré de manière à détecter l'état de fonctionnement du panneau photovoltaïque en vue d'obtenir le paramètre d'état du panneau photovoltaïque ; et
un premier contrôleur, configuré de manière à recevoir le paramètre d'état du panneau photovoltaïque, et à commander le panneau photovoltaïque sur la base du paramètre d'état du panneau photovoltaïque.

10. Système selon la revendication 9, dans lequel le premier capteur comprend l'un quelconque ou plusieurs des capteurs ci-dessous :
un capteur de tension, configuré de manière à détecter un paramètre d'état de tension du panneau photovoltaïque ;
un capteur de position, configuré de manière à détecter un paramètre d'état de position du panneau photovoltaïque, dans lequel le premier contrôleur est configuré de manière à ajuster une position du panneau photovoltaïque sur la base d'un signal connexe à une position du panneau photovoltaïque ; et
un capteur de température, configuré de manière à détecter un paramètre d'état de température du panneau photovoltaïque.

11. Système selon la revendication 8, dans lequel il est déterminé si le paramètre d'état du panneau photovoltaïque est transmis correctement au dispositif de commande, en vue d'obtenir un résultat de détermination, et le dispositif de commande comprend en outre :
un ordinateur supérieur, configuré de manière à recevoir le résultat de détermination, et à surveiller un état du panneau photovoltaïque sur la base du résultat de détermination.

12. Système électrique photovoltaïque, comprenant l'appareil destiné à détecter un état de fonctionnement d'un panneau photovoltaïque selon la revendication 6 ou 7, ou le système destiné à détecter un état de fonctionnement d'un panneau photovoltaïque selon l'une quelconque des revendications 8 à 11.
